# EUROPÄISCHE PATENTSCHRIFT

(11) **EP 2 721 648 B1**
(45) Veröffentlichungstag und Bekanntmachung des Hinweises auf die Patenterteilung: **20.12.2017**
(21) Anmeldenummer: 12730798.1
(22) Anmeldetag: 18.06.2012
(51) Int. Cl.: H01L 31/08

(54) **HALBLEITERDRIFTDETEKTOR UND ENTSPRECHENDES BETRIEBSVERFAHREN**
SEMICONDUCTOR DRIFT DETECTOR AND CORRESPONDING OPERATING METHOD
DÉTECTEUR DE DÉRIVE À SEMI-CONDUCTEUR ET PROCÉDÉ DE FONCTIONNEMENT CORRESPONDANT

(30) Priorität: 17.06.2011 DE 102011104489
(43) Veröffentlichungstag der Anmeldung: 23.04.2014
(73) Patentinhaber: PNDetector GmbH, 81735 München (DE); PNSensor GmbH, 80803 München (DE)
(72) Erfinder: LUTZ, Gerhard, 81739 München (DE); SOLTAU, Heike, 80803 München (DE); NICULAE, Adrian, 82194 Gröbenzell (DE)
(74) Vertreter: Maiwald Patentanwalts GmbH
(86) Internationale Anmeldenummer: PCT/EP2012/002566
(87) Internationale Veröffentlichungsnummer: WO 2012/171664

(56) Entgegenhaltungen:
- DE-A1-102009 024 928
- DE-B3-102007 017 640
- DE-B3-102008 014 578
- US-B2- 7 238 949
- EGGERT T ET AL: "The spectral response of silicon X-ray detectors", NUCLEAR INSTRUMENTS & METHODS IN PHYSICS RESEARCH. SECTION A: ACCELERATORS, SPECTROMETERS, DETECTORS, AND ASSOCIATED EQUIPMENT, ELSEVIER BV * NORTH-HOLLAND, NETHERLANDS, Bd. 568, Nr. 1, 30. November 2006 (2006-11-30), Seiten 1-11, XP027925588, ISSN: 0168-9002 [gefunden am 2006-11-30]
- GUAZZONIA C ET AL: "Low noise, high count rate charge amplifier with detector embedded front-end transistor and continuous reset", NUCLEAR SCIENCE SYMPOSIUM, 1999. CONFERENCE RECORD. 1999 IEEE 24-30 OCTOBER 1999, PISCATAWAY, NJ, USA,IEEE, US, Bd. 1, 24. Oktober 1999 (1999-10-24), Seiten 356-359, XP010500147, DOI: 10.1109/NSSMIC.1999.842508 ISBN: 978-0-7803-5696-2
- SAMPIETRO M ET AL: "Bipolar feedback transistor integrated on detector with JFET for continuous reset", NUCLEAR INSTRUMENTS & METHODS IN PHYSICS RESEARCH. SECTION A: ACCELERATORS, SPECTROMETERS, DETECTORS, AND ASSOCIATED EQUIPMENT, ELSEVIER BV * NORTH-HOLLAND, NETHERLANDS, Bd. 439, Nr. 2-3, 11. Januar 2000 (2000-01-11), Seiten 368-372, XP004253666, ISSN: 0168-9002, DOI: 10.1016/S0168-9002(99)00914-6
- SONSKY J ET AL: "Low noise p-channel JFETs for x-ray spectroscopy with silicon drift detectors", NUCLEAR SCIENCE SYMPOSIUM CONFERENCE RECORD, 2000 IEEE LYON, FRANCE 15-20 OCT. 2000, PISCATAWAY, NJ, USA,IEEE, US, vol. 2, 15 October 2000 (2000-10-15), pages 9_204-9_208, XP010556862, DOI: 10.1109/NSSMIC.2000.949901 ISBN: 978-0-7803-6503-2
- GUAZZONI C ET AL: "Two-chip charge amplifier system for high resolution, high count rate readout", NUCLEAR INSTRUMENTS & METHODS IN PHYSICS RESEARCH. SECTION A: ACCELERATORS, SPECTROMETERS, DETECTORS, AND ASSOCIATED EQUIPMENT, ELSEVIER BV * NORTH-HOLLAND, NL, vol. 458, no. 1-2, 1 February 2001 (2001-02-01), pages 370-374, XP027324644, ISSN: 0168-9002 [retrieved on 2001-02-01]
- GUAZZONI C ET AL: "Detector embedded device for continuous reset of charge amplifiers: choice between bipolar and MOS transistor", NUCLEAR INSTRUMENTS & METHODS IN PHYSICS RESEARCH. SECTION A: ACCELERATORS, SPECTROMETERS, DETECTORS, AND ASSOCIATED EQUIPMENT, ELSEVIER BV * NORTH-HOLLAND, NL, vol. 443, no. 2-3, 1 April 2000 (2000-04-01), pages 447-450, XP004192461, ISSN: 0168-9002, DOI: 10.1016/S0168-9002(99)01152-3

## Beschreibung

Die Erfindung betrifft einen Halbleiterdriftdetektor zur Detektion von Strahlung und ein entsprechendes Betriebsverfahren.

Es ist aus dem Stand der Technik bekannt, zur Strahlungsdetektion sogenannte Halbleiterdriftdetektoren einzusetzen. Hierbei erzeugt die zu detektierende Strahlung in einem schwach dotierten, verarmten Halbleitersubstrat Signalelektronen, wobei an einer Oberfläche des Halbleitersubstrats mehrere ringförmige und konzentrisch angeordnete Elektroden angeordnet sind, die in dem Halbleitersubstrat ein Driftfeld erzeugen, durch das die von der Strahlung erzeugten Signalelektronen zu einem mittig angeordneten Ausleseelement driften, das die Signalelektronen und damit die aufgenommene Strahlung detektiert.

Das Ausleseelement kann hierbei aus einem integrierten SSJFET-Transistor (SSJFET: Single Sided Junction Field Effect Transistor) bestehen (vgl. V. Radeka et al., IEEE Electron Device Lett., vol. 10, pp. 91, 1989).

Diese herkömmlichen Halbleiterdriftdetektoren erlauben es, strahlungsgenerierte Signalladungen schnell und sehr genau zu messen. Zum einen liegt das an der kleinen Kapazität der Ladungssammlungsanode. Zum anderen ist aber auch vorteilhaft, dass aufgrund der Integration des Auslesetransistors in den Halbleiterdriftdetektor keine Verbindungsleitungen zu einer externen Elektronik erforderlich sind, so dass die mit derartigen Verbindungsleitungen üblicherweise verbundenen parasitären Kapazitäten entfallen.

Derartige Halbleiterdriftdetektoren sind seit Jahren im Einsatz für spektroskopische Untersuchungen mit Hilfe von Röntgenstrahlung. Beispielsweise werden derartige Halbleiterdriftdetektoren in Elektronenmikroskopen eingesetzt, um Fluoreszenzstrahlung zu messen, deren spektroskopische Zusammensetzung eine Elementanalyse der untersuchten Probe erlaubt. Hierbei ist es manchmal wünschenswert, nicht nur die photonengenerierten Signalladungsträger in dem Halbleiterdriftdetektor zu erfassen, sondern auch die durch einfallende Elektronen in dem Halbleiterdriftdetektor generierte Ionisation zu messen. Dies ist grundsätzlich möglich, wenn der kontinuierlich eintreffende Anodenstrom und nicht die in Ladungspaketen eintreffende, von einzelnen Photonen erzeugte Ladung gemessen wird.

Die herkömmlichen Halbleiterdriftdetektoren sind jedoch nur unter wesentlichen Einschränkungen dazu in der Lage, sowohl die Photonenenergie der einfallenden Photonen als auch den Signalladungsträgerstrom zu messen, der durch einfallende Elektronen generiert wird.

Ferner ist zum Stand der Technik hinzuweisen auf DE 10 2007 017 640 B3, US 2008/0217543 A1, US 7 514 687 B2, DE 10 2009 024 928 A1, US 7 238 949 B2, DE 10 2009 026 946 A1, DE 10 2008 014 578 B3, US 7 193 216 B2 und NICULAE, A. et al.: "Optimized readout methods of silicon drift detectors for highresolution X-ray spectroscopy", Nuclear Instruments and Methods in Physics Research A 568 (2006), 336-342. Weiterhin wird bzgl. des Standes der Technik auch hingewiesen auf
EGGERT T ET AL: "The spectral response of silicon X-ray detectors", NUCLEAR INSTRUMENTS & METHODS IN PHYSICS RESEARCH. SECTION A: ACCELERATORS, SPECTROMETERS, DETECTORS, AND ASSOCIATED EQUIPMENT, ELSEVIER BV * NORTH-HOLLAND, NETHERLANDS, Bd. 568, Nr. 1, 30. November 2006 (2006-11-30), Seiten 1-11, XP027925588, ISSN: 0168-9002
GUAZZONIA C ET AL: "Low noise, high count rate charge amplifier with detector embedded front-end transistor and continuous reset", NUCLEAR SCIENCE SYMPOSIUM, 1999. CONFERENCE RECORD. 1999 IEEE 24-30 OCTOBER 1999, PISCATAWAY, NJ, USA,IEEE, US, Bd. 1, 24. Oktober 1999 (1999-10-24), Seiten 356-359, XP010500147, DOI: 10.1109/NSSMIC.1999.842508 ISBN: 978-0-7803-5696-2
SAMPIETRO M ET AL: "Bipolar feedback transistor integrated on detector with JFET for continuous reset", NUCLEAR INSTRUMENTS & METHODS IN PHYSICS RESEARCH. SECTION A: ACCELERATORS, SPECTROMETERS, DETECTORS, AND ASSOCIATED EQUIPMENT, ELSEVIER BV * NORTH-HOLLAND, NETHERLANDS, Bd. 439, Nr. 2-3, 11. Januar 2000 (2000-01-11), Seiten 368-372, XP004253666, ISSN: 0168-9002, DOI: 10.1016/S0168-9002(99)00914-6 1
SONSKY J ET AL: "Low noise p-channel JFETs for x-ray spectroscopy with silicon drift detectors", NUCLEAR SCIENCE SYMPOSIUM CONFERENCE RECORD, 2000 IEEE LYON, FRANCE 15-20 OCT. 2000, PISCATAWAY, NJ, USA,IEEE, US, Bd. 2, 15. Oktober 2000 (2000-10-15), Seiten 9_204-9_208, XP010556862, DOI: 10.1109/ NSSMIC.2000.949901 ISBN: 978-0-7803-6503-2
GUAZZONI C ET AL: "Detector embedded device for continuous reset of charge amplifiers: choice between bipolar and MOS transistor", NUCLEAR INSTRUMENTS & METHODS IN PHYSICS RESEARCH. SECTION A: ACCELERATORS, SPECTROMETERS, DETECTORS, AND ASSOCIATED EQUIPMENT, ELSEVIER BV * NORTH-HOLLAND, NL, Bd. 443, Nr. 2-3, 1. April 2000 (2000-04-01), Seiten 447-450, XP004192461, ISSN: 0168-9002, DOI: 10.1016/S0168-9002(99)01152-3. Der Erfindung liegt deshalb die Aufgabe zugrunde, die vorstehend beschriebenen herkömmlichen Halbleiterdriftdetektoren entsprechend zu verbessern.

Diese Aufgabe wird durch einen erfindungsgemäßen Halbleiterdriftdetektor gemäß dem unabhängigen Anspruch 1, Verwendungen gemäß der unabhängigen Ansprüche 16 und 17 und ein entsprechendes Betriebsverfahren gemäß dem unabhängigen Anspruch 18 gelöst.

Der erfindungsgemäße Halbleiterdriftdetektor entspricht teilweise den vorstehend beschriebenen herkömmlichen Halbleiterdriftdetektoren und weist ein Halbleitersubstrat auf, in dem im Betrieb durch einfallende Strahlung Signalladungsträger generiert werden, die dann als Maß für die einfallende Strahlung gemessen werden. Zum einen können die Signalladungsträger hierbei durch einfallende Photonen (z.B. Röntgenphotonen) mit einer bestimmten Photonenenergie generiert werden, wobei die einfallende Strahlung beispielsweise Röntgenfluoreszenzstrahlung sein kann. Zum anderen können die Signalladungsträger aber auch durch eine Vielzahl von einfallenden Elektronen (z.B. rückgestreute Elektronen) generiert werden, wobei die einfallenden Elektronen einen bestimmten Signalladungsträgerstrom erzeugen bzw. bilden.

Darüber hinaus weist der erfindungsgemäße Halbleiterdriftdetektor eine Auslese-Anode auf, um in Abhängigkeit von den strahlungsgenerierten Signalladungsträgern ein elektrisches Ausgangssignal zu erzeugen, das ein Maß für die einfallende Strahlung bildet.

Ferner weist auch der erfindungsgemäße Halbleiterdriftdetektor einen Lösch-Kontakt auf, um die in dem Halbleitersubstrat angesammelten Signalladungsträger zu löschen, was an sich bereits von herkömmlichen Halbleiterdriftdetektoren bekannt ist.

Der erfindungsgemäße Halbleiterdriftdetektor unterscheidet sich von einigen der eingangs beschriebenen herkömmlichen Halbleiterdriftdetektoren dadurch, dass der Halbleiterdriftdetektor wahlweise in einem ersten Betriebsmodus oder in einem zweiten Betriebsmodus betrieben werden kann.

In dem ersten Betriebsmodus misst der Halbleiterdriftdetektor dabei die Photonenenergie der einzelnen einfallenden Photonen, Elektronen bzw. Ionen oder - allgemeiner - von ionisierenden Strahlungsquanten oder Teilchen.

In dem zweiten Betriebsmodus erfasst der Halbleiterdriftdetektor dagegen den Signalladungsträgerstrom, der durch eine Vielzahl einfallender Elektronen generiert wird.

Der erfindungsgemäße Halbleiterdriftdetektor eignet sich also im Gegensatz zu den herkömmlichen Halbleiterdriftdetektoren sowohl zur Ermittlung der Energie der einfallenden Photonen als auch zur Messung des durch eine Vielzahl einfallender Elektronen generierten Signalladungsträgerstroms.

Hierzu ist bei der Erfindung in das Halbleitersubstrat des Halbleiterdriftdetektors ein Reset-Transistor integriert, der die Auslese-Anode mit dem Lösch-Kontakt verbindet, um die photonengenerierten Signalladungsträger und/oder die elektronengenerierten Signalladungsträger zu dem Lösch-Kontakt abzuführen, wodurch die Messung des Signalladungsträgerstroms und die Messung der Photonenenergie ermöglicht wird.

Der Reset-Transistor weist einen Leitungskanal mit einer bestimmten Kanallänge und einer bestimmten Kanalbreite auf, wobei die Kanallänge des Leitungskanals wesentlich größer ist als die Kanalbreite. Bei dem Reset-Transistor handelt es sich also um einen langkanaligen Transistor, der in seiner Funktionsweise einem durch die angelegte Gate-Spannung steuerbaren Widerstand entspricht.

Beispielsweise kann die Kanallänge größer sein als 10 µm, 20 µm, 50µm oder 100 µm. Die Erfindung ist jedoch hinsichtlich der Kanallänge des Leitungskanals des Reset-Transistors nicht auf die vorstehend genannten beispielhaften Werte beschränkt, sondern grundsätzlich auch mit anderen Werten für die Kanallänge realisierbar.

Hierbei ist jedoch zu erwähnen, dass der Leitungskanal des langkanaligen Reset-Transistors einen einstellbaren elektrischen Widerstand aufweist, wobei der Widerstand durch Anlegen einer Gate-Spannung an das Gate des Reset-Transistors einstellbar ist, wie noch detailliert beschrieben wird.

Darüber hinaus weist der erfindungsgemäße Halbleiterdriftdetektor vorzugsweise einen in das Halbleitersubstrat integrierten Auslese-Transistor mit einer Source, einem Gate und einer Drain auf, wobei das Gate des Auslese-Transistors elektrisch leitend mit der Auslese-Anode verbunden ist. Bei dem Auslese-Transistor kann es sich beispielsweise um einen bereits eingangs erwähnten SSJFET-Transistor handeln, der an sich aus dem Stand der Technik bekannt ist und deshalb nicht näher beschrieben werden muss. Die Erfindung ist jedoch hinsichtlich des Typs des Auslese-Transistors nicht auf einen SSJFET-Transistor beschränkt, sondern grundsätzlich auch mit anderen Transistortypen realisierbar.

Weiterhin ist zu erwähnen, dass der Halbleiterdriftdetektor ringförmig aufgebaut ist Bei einem, nicht der Erfidnung entsprechenden, Halbleiterdriftdetektor wären in Driftrichtung linear hintereinander mehrere Driftelektroden vorgesehen, die in dem Halbleitersubstrat ein linear ausgerichtetes Driftfeld erzeugen würden. Der erfindungsgemäße Halbleiterdriftdetektor ist jedoch ringförmig und weist deshalb mindestens einen Driftring auf, der die Auslese-Anode ringförmig umgibt und in dem Halbleitersubstrat ein elektrisches Driftfeld erzeugt, das die Signalladungsträger zu der Auslese-Anode driften lässt. Der innerste Driftring ist von einem von innen nach außen verlaufenden Schlitz unterbrochen, wobei der Reset-Transistor in dem Schlitz angeordnet ist, so dass der Leitungskanal des Reset-Transistors entlang dem Schlitz verläuft.

Vorzugsweise verläuft der Schlitz in dem inneren Driftring hierbei radial, jedoch sind auch andere Ausrichtungen des Schlitzes realisierbar, wie beispielsweise ein mäanderförmiger Verlauf des Schlitzes von innen nach außen.

Weiterhin ist zu erwähnen, dass der Schlitz in dem innersten Driftring vorzugsweise von innen nach außen durchgeht, so dass der innerste Driftring von dem Schlitz vollständig unterbrochen wird. Dies ist beispielsweise dann sinnvoll, wenn der Lösch-Kontakt außerhalb des innersten Driftrings angeordnet ist. Es ist jedoch im Rahmen der Erfindung nicht zwingend erforderlich, dass der Schlitz in dem innersten Ring von innen nach außen durchgeht. Es reicht vielmehr, wenn der Schlitz bis zu dem Lösch-Kontakt reicht, um die Signalladungsträger zu dem Lösch-Kontakt abführen zu können. Weiterhin ist zu erwähnen, dass der Driftring vorzugsweise mit einem ersten Dotierungstyp (z.B. p-Dotierung) dotiert ist, wobei das Halbleitersubstrat in dem Schlitz des innersten Driftrings mit einer tiefen Dotierungsimplantation des ersten Dotierungstyps (z.B. p-Dotierung) unterlegt ist. Diese tiefe Dotierung bildet eine Abschirmung zwischen dem Halbleiterkörper und dem Reset-Transistor und übernimmt die Funktion der Driftfelderzeugung vom Driftring. Somit bestehen keine Beschränkungen bezüglich der Breite des Schlitzes.

Bei dem ersten Dotierungstyp handelt es sich also vorzugsweise um eine p-Dotierung, während der zweite Dotierungstyp vorzugsweise durch eine n-Dotierung gebildet wird. Es ist jedoch im Rahmen der Erfindung grundsätzlich möglich, die Dotierungsverhältnisse zu invertieren, so dass es sich bei dem ersten Dotierungstyp dann um eine n-Dotierung handelt, während der zweite Dotierungstyp durch eine p-Dotierung gebildet wird.

Zu den Dotierungsverhältnissen in dem erfindungsgemäßen Halbleiterdriftdetektor ist weiterhin zu erwähnen, dass die Auslese-Anode vorzugsweise entsprechend dem zweiten Dotierungstyp (z.B. n-Dotierung) dotiert ist und dass der Leitungskanal des langkanaligen Reset-Transistors vorzugsweise eine tiefe Dotierungsimplantation des zweiten Dotierungstyps (z.B. n-Dotierung) aufweist. Alternativ besteht jedoch im Rahmen der Erfindung auch die Möglichkeit, dass der Reset-Transistor als Enhancement-Transistor, Depletion-Transistor oder als JFET (JFET: Junction Gate Field Effect Transistor) ausgebildet ist.

Ferner besteht im Rahmen der Erfindung die Möglichkeit, dass ein Filter vorgesehen ist, das die einfallende Strahlung spektral filtert. Vorzugsweise ist dieses Filter so ausgebildet, dass die einfallenden Elektronen unterhalb einer bestimmten Elektronenenergie größtenteils oder vollständig ausgefiltert werden, während die einfallenden Photonen (z.B. Röntgenphotonen) durchgelassen werden. Dies ist vorteilhaft, wenn die Photonenenergie der einfallenden Photonen gemessen werden soll, während die einfallenden Elektronen nicht interessieren.

Hierbei besteht die Möglichkeit, dass das Filter direkt auf den Halbleiterdriftdetektor aufgebracht oder sogar in den Halbleiterdriftdetektor baulich integriert ist. Alternativ besteht die Möglichkeit, dass das Filter räumlich getrennt von dem Halbleiterdriftdetektor im Strahlengang angeordnet ist.

Alternativ zu dem Filter besteht auch die Möglichkeit, den Detektor durch elektrische oder magnetische Felder vor Elektronen oder anderen elektrisch geladenen Teilchen abzuschirmen (Elektronenfalle). Damit wird es dann möglich, durch Ein- oder Abschalten des Feldes, den gleichen Detektor wahlweise oder sukzessive zur spektralen Messung von Photonen und/oder des Elektronenstroms einzusetzen.

Mit den bisher dargelegten Vorschlägen wird eine wesentliche Verbesserung der Signalauslesegeschwindigkeit erreicht, was insbesondere für die Elektronenmessung gilt. Hierbei besteht jedoch das Problem, dass die Auslesegeschwindigkeit durch die von der Einfallsposition der Strahlung abhängigen unterschiedlichen Driftzeiten der Signalladungsträger dominiert wird. Hierbei ist zu berücksichtigen, dass die Driftdauer mit dem Quadrat der zurückzulegenden Entfernung zunimmt. Bei einem Halbleiterdriftdetektor mit einer einzigen, relativ großen strahlungssensitiven Detektorfläche brauchen die strahlungsgenerierten Signalladungsträger also relativ lange, um in dem Halbleiterdriftdetektor die erforderliche Strecke zurückzulegen, wodurch die Auslesegeschwindigkeit begrenzt wird. Zur Lösung dieses Problems ist in einer Variante der Erfindung vorgesehen, dass der Halbleiterdriftdetektor mehrere Detektorzellen zur Detektion der einfallenden Strahlung aufweist, wobei die Detektorzellen räumlich voneinander getrennt sind und entsprechend der einfallenden Strahlung unabhängig voneinander Signalladungsträger sammeln.

Im einfachsten Fall weisen die einzelnen Detektorzellen jeweils eine separate Ausleseelektronik auf, wodurch jedoch der Ausleseaufwand mit der Anzahl der Detektorzellen ansteigt.

Vorzugsweise ist deshalb eine gemeinsame Ausleseelektronik vorgesehen, welche die Detektorzellen parallel ausliest. Hierzu können die Auslesetransistoren der Detektorzellen jeweils mit ihrer Source, Drain oder dem Lösch-Kontakt untereinander verbunden sein.

Ferner ist in diesem Zusammenhang zu bemerken, dass die Detektorzellen jeweils hexagonal sein können, was eine große Packungsdichte ermöglicht. Darüber hinaus können die Detektorzellen gemeinsam auf dem selben Halbleitersubstrat angeordnet sein. Die Verbindungen zwischen den Auslesetransistoren der einzelnen Detektorzellen können dabei direkt auf dem monolithischen mehrzelligen Halbleiterdriftdetektor erfolgen.

Ferner ist zu erwähnen, dass die Erfindung nicht auf den vorstehend beschriebenen erfindungsgemäßen Halbleiterdriftdetektor als einzelnes Bauteil beschränkt ist, sondern auch ein Elektronenmikroskop mit einem solchen Halbleiterdriftdetektor umfasst, wobei die erfindungsgemäße Gestaltung des Halbleiterdriftdetektors die Messung von Fluoreszenzstrahlung und die Messung von rückgestreuten Elektronen ermöglicht.

Darüber hinaus umfasst die Erfindung auch ein entsprechendes Betriebsverfahren für einen erfindungsgemäßen Halbleiterdriftdetektor, wie sich bereits aus der vorstehenden Beschreibung ergibt, so dass hinsichtlich des Betriebsverfahrens zur Vermeidung von Wiederholungen auf die vorstehende Beschreibung verwiesen wird.

Andere vorteilhafte Weiterbildungen der Erfindung sind in den Unteransprüchen gekennzeichnet oder werden nachstehend zusammen mit der Beschreibung der bevorzugten Ausführungsbeispiele der Erfindung anhand der Figuren näher erläutert. Es zeigen:
- Figur 1: eine Querschnittsansicht durch einen erfindungsgemäßen Halbleiterdriftdetektor entlang der Schnittlinie A-A in Figur 2,
- Figur 2: eine Aufsichtsdarstellung auf den Halbleiterdriftdetektor gemäß Figur 1,
- Figur 3A: eine Querschnittsansicht durch den Halbleiterdriftdetektor entlang der Schnittlinie B-B in Figur 2 mit einem Enhancement-Transistor als ResetTransistor,
- Figur 3B: eine Abwandlung von Figur 3A mit einem DepletionTransistor als Reset-Transistor,
- Figur 3C: eine Abwandlung von Figur 3A mit einem JFET als Reset-Transistor,
- Figur 4: ein Flussdiagramm zur Verdeutlichung des Betriebsverfahrens des erfindungsgemäßen Halbleiterdriftdetektors zur Messung eines Elektronenstroms,
- Figur 5: ein Flussdiagramm zur Verdeutlichung des Betriebsverfahrens des erfindungsgemäßen Halbleiterdriftdetektors zur Ladungsmessung mit kontinuierlichem Reset,
- Figur 6: ein Flussdiagramm zur Verdeutlichung eines Betriebsverfahrens des erfindungsgemäßen Halbleiterdriftdetektors zur Ladungsmessung mit gepulstem Reset,
- Figur 7: ein Ausführungsbeispiel einer Rückkopplungsschaltung,
- Figur 8: ein anderes Ausführungsbeispiel einer Rückkopplungsschaltung, sowie
- Figur 9: eine schematische Darstellung eines Halbleiterdriftdetektors mit mehreren hexagonalen Detektorzellen.

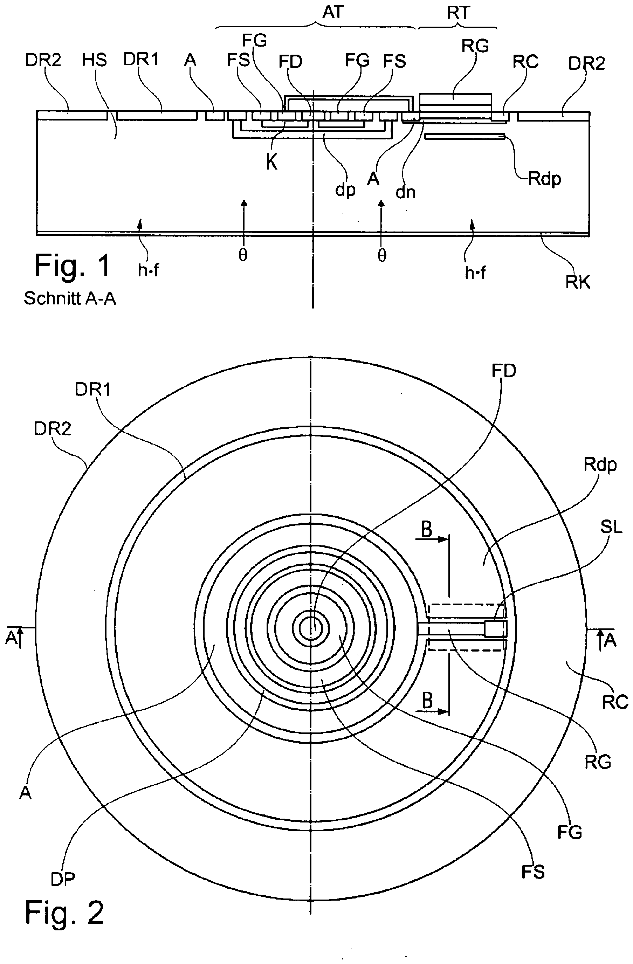

Die Figuren 1, 2 und 3A zeigen verschiedene Ansichten eines erfindungsgemäßen Halbleiterdriftdetektors, der zur Strahlungsdetektion eingesetzt werden kann, wie beispielsweise in einem Elektronenmikroskop.

Zum einen ermöglicht der erfindungsgemäße Halbleiterdriftdetektor die Erfassung von Elektronen ⊖, wie beispielsweise von rückgestreuten ("back scattered") Elektronen ⊖ in dem Elektronenmikroskop.

Zum anderen ermöglicht der erfindungsgemäße Halbleiterdriftdetektor aber auch die Messung der Photonenenergie von einfallenden Photonen h·f, die beispielsweise von Röntgenfluoreszenzstrahlung herrühren.

Hierzu weist der erfindungsgemäße Halbleiterdriftdetektor ein n-dotiertes Halbleitersubstrat HS auf, in dem die einfallenden Elektronen ⊖ und die einfallenden Photonen h·f Signalladungsträger erzeugen, die dann von dem Halbleiterdriftdetektor erfasst werden.

Auf der Strahlungseintrittsseite weist der Halbleiterdriftdetektor einen p-dotierten Rückkontakt RK auf, der mit dem schwach n-dotierten Halbleitersubstrat HS eine in Sperrrichtung gepolte Diode bildet und zur Verarmung des Halbleitersubstrats HS dient, wobei in dem Halbleitersubstrat HS durch Strahlungseinwirkung entstandene Löcher über den Rückkontakt RK aus dem Halbleitersubstrat HS abgesaugt werden, was an sich aus dem Stand der Technik bekannt ist.

Hierbei ist jedoch zu erwähnen, dass der Rückkontakt RK strahlungsdurchlässig ausgebildet ist, und zwar sowohl für die einfallenden Photonen h·f als auch für die einfallenden Elektronen ⊖, damit beide Strahlungsarten von dem Halbleiterdriftdetektor erfasst werden können.

An der dem Rückkontakt RK gegenüberliegenden Seite weist der Halbleiterdriftkontakt mehrere konzentrisch angeordnete Driftringe DR1, DR2 auf, wobei die Driftringe DR1, DR2 in dem Halbleitersubstrat HS ein elektrisches Driftfeld erzeugen, das die strahlungsgenerierten Signalladungsträger zu einer Auslese-Anode A driften lässt, die innerhalb des innersten Driftrings DR1 angeordnet ist.

Darüber hinaus ist in den erfindungsgemäßen Halbleiterdriftdetektor ein Auslese-Transistor AT integriert, der eine mittig angeordnete Drain FD, eine ringförmig um die Drain FD angeordnete Source FS, einen dotierten Leitungskanal K und ein über dem Leitungskanal K zwischen der Source FS und der Drain FD angeordnetes Gate FG aufweist, wobei das Gate FG des Auslese-Transistors AT mit der Auslese-Anode A verbunden ist. Darüber hinaus ist der Auslese-Transistor AT in dem Halbleitersubstrat HS von einer tiefen p-Dotierung dp unterlegt. Der Auslese-Transistor AT erzeugt also in Abhängigkeit von den an der Auslese-Anode A angesammelten strahlungsgenerierten Signalladungsträgern ein elektrisches Ausgangssignal, das ein Maß für die einfallende Strahlung bildet.

Darüber hinaus enthält der erfindungsgemäße Halbleiterdriftdetektor noch einen Reset-Transistor RT und einen Lösch-Kontakt RC, wobei der Reset-Transistor RT die Auslese-Anode A mit dem Lösch-Kontakt RC verbindet, um die an der Auslese-Anode A gesammelten strahlungsgenerierten Signalladungsträger zu dem Lösch-Kontakt RC abzuführen.

Der Reset-Transistor RT ist hierbei als langkanaliger Transistor ausgebildet und in einem radial in dem inneren Driftring DR1 verlaufenden Schlitz SL angeordnet und radial ausgerichtet. Im Bereich des Leitungskanals des Reset-Transistors RT befindet sich unterhalb eines Gates RG eine vergrabene schwache n-Dotierung dn, wie insbesondere aus Figur 1 ersichtlich ist.

Darüber hinaus befindet sich in dem Halbleitersubstrat HS unterhalb des Reset-Transistors eine vergrabene p-Dotierung Rdp, wie insbesondere aus Figur 1 ersichtlich ist.

Der Reset-Transistor RT verbindet die Auslese-Anode A mit dem Lösch-Kontakt RC und entspricht in seiner Funktionsweise einem durch die angelegte Gate-Spannung an dem Gate RG steuerbaren Widerstand.

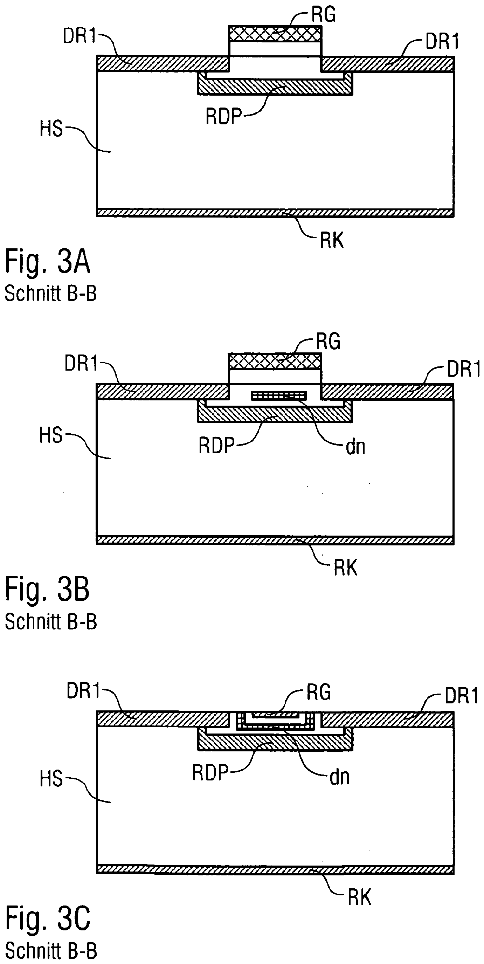

Die Figuren 3A-3C zeigen verschiedene Varianten des Reset-Transistors RT als n-Kanal-Enhancement-Transistor (Figur 3A), als n-Kanal-Depletion-Transistor (Figur 3B) bzw. als n-Kanal-JFET (Figur 3C).

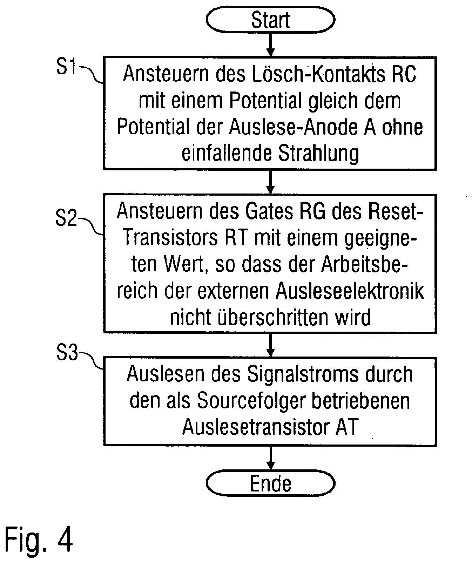

Im Folgenden wird nun unter Bezugnahme auf Figur 4 ein erster Betriebsmodus beschrieben, der zur Messung des Elektronenstroms geeignet ist, wobei der Elektronenstrom durch die einfallenden Elektronen ⊖ gebildet wird, wobei es sich beispielsweise um rückgestreute Elektronen ⊖ handeln kann.

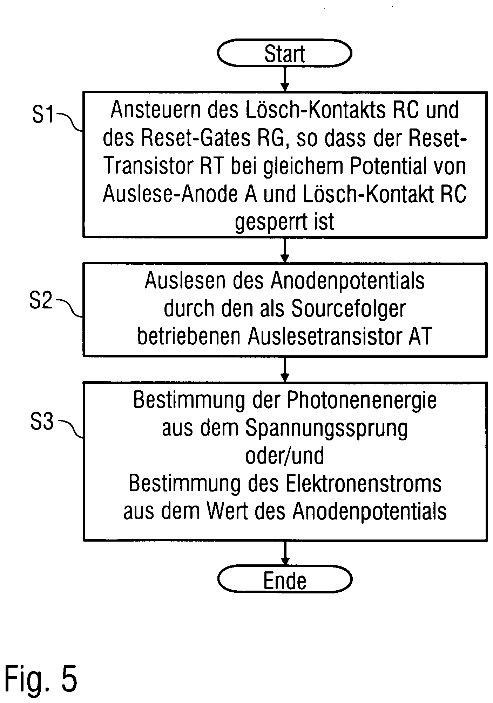

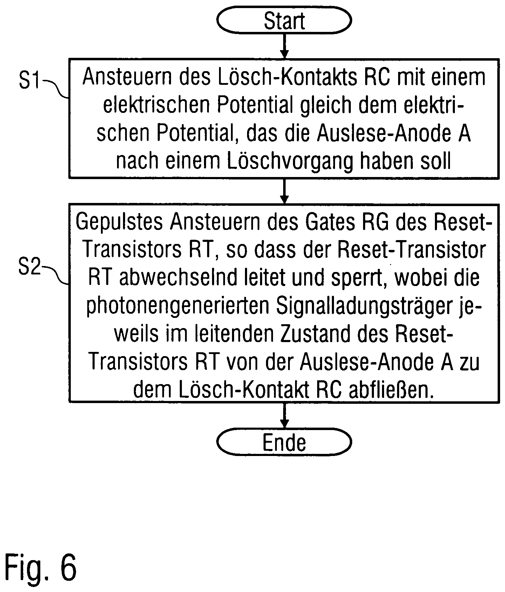

Hierbei und im folgenden (Figuren 5 und 6) gehen wir aus didaktischen Gründen in der Beschreibung davon aus, dass der Auslese-Transistor AT als Source-Folger betrieben wird. Er dient dabei dazu, bei festem Potential an dem Reset-Kontakt RC, die an der Auslese-Anode A aufgrund der Signale auftretende Spannungsänderung niederohmig nach außen zu übertragen. Natürlich ist es auch möglich, den Auslese-Transistor AT mit fester Source- und Gatespannung zu betreiben und die Änderung des Drainstromes als Maß für die Anodenspannungsänderung bzw. den Reset oder Signalstrom zu nehmen.

Weiterhin besteht die Möglichkeit, mithilfe einer geeigneten Rückkopplung das Potential an dem Reset-Kontakt RC so zu verändern, dass der gesamte Signalstrom über den Reset-Transistor RT abfließt ohne das Anodenpotential zu verändern. Auf diesen Punkt wird später eingegangen werden.

In einem Schritt S1 wird der Lösch-Kontakt RC auf ein elektrisches Potential gelegt, auf das auch die Auslese-Anode A gesetzt werden soll, solange der Signalstrom null ist. Das Gate RG des langkanaligen Reset-Transistors RT wird in einem Schritt S2 so angesteuert, dass der Leitungskanal des Reset-Transistors RT, der als einstellbarer Widerstand fungiert und an dem der Signalstrom einen Spannungsabfall bewirkt, einen geeigneten Wert hat, d.h. genügend groß ist, um bei kleinen Strömen einen genügend großen Spannungsabfall zu erhalten, und klein genug, um für die größten zu erwartenden Ströme im Arbeitsbereich der nachfolgenden, hier nicht dargestellten Elektronik zu bleiben.

In einem weiteren Schritt S3 wird dann der durch den Signalstrom bewirkte, an dem Reset-Transistor RT auftretende Spannungsabfall durch den als Source-Folger betriebenen Auslese-Transistor AT ausgelesen und niederohmig nach außen übertragen.

Ein wesentlicher Vorteil der erfindungsgemäßen Anordnung gegenüber einer direkten Strommessung ist die Schnelligkeit, mit welcher die Auslesespannung dem Signalstrom folgen kann. Weiterhin ist sie weitgehend immun gegenüber unerwünschten Einkopplungen.

Im Folgenden wird nun unter Bezugnahme auf das Flussdiagramm in Figur 5 ein zweiter Betriebsmodus beschrieben, der zur Ladungsmessung mit kontinuierlichem Reset (Self-Reset) dient.

In einem Schritt S1 werden der Lösch-Kontakt RC und das Gate RG des Reset-Transistors RT so angesteuert, dass der Reset-Transistor RT bei gleichem Potential der Auslese-Anode A und des Lösch-Kontakts RC gesperrt ist. Falls nun ein kleiner (Dunkel-)Strom zu der Auslese-Anode A fließt, so wird sich deren Potential so lange verändern, bis der Reset-Transistor RT ganz wenig leitend wird.

Falls nun ein Signalladungspaket an die Auslese-Anode A kommt, so bewirkt dieses Signalladungspaket eine Spannungsstufe, die sich aus dem Verhältnis zwischen der eintreffenden Signalladung und der Kapazität des Eingangsknotens (Anode) ergibt.

Im Schritt S2 wird das Anodenpotential und damit auch dieser Spannungssprung mithilfe des als Sourcefolger geschalteten Ausgangstransistor niederohmig nach außen übertragen. Danach wird der Reset-Transistor RT stärker leitend und das System geht langsam in den Ausgangszustand zurück. Das Verhalten ist hierbei funktional sehr ähnlich zu demjenigen Verhalten herkömmlicher Halbleiterdriftdetektoren mit einer Reset-Diode.

In einem weiteren Schritt S3 werden aus dem Potentialsprung die Photonenenergie und/oder aus dem Anodenpotential der Elektronenstrom ermittelt.

Im Folgenden wird nun unter Bezugnahme auf das Flussdiagramm in Figur 6 ein dritter Betriebsmodus beschrieben, in dem eine Ladungsmessung mit einem gepulsten Reset erfolgt.

In einem Schritt S1 wird hierbei der Lösch-Kontakt RC mit einem elektrischen Potential gleich dem elektrischen Potential angesteuert, das die Auslese-Anode A nach einem Löschvorgang annehmen soll.

In einem Schritt S2 erfolgt dann ein gepulstes Ansteuern des Gates RG des Reset-Transistors RT, so dass der Reset-Transistor RT abwechselnd leitet und sperrt, wobei die photonengenerierten Signalladungsträger jeweils im leitenden Zustand des Reset-Transistors RT von der Auslese-Anode A zu dem Lösch-Kontakt RC abfließen.

Das Verhalten ist funktional sehr ähnlich zu demjenigen Verhalten herkömmlicher Halbleiterdriftdetektoren basierend auf der Reset-Diode mit dem Unterschied, dass das Gate RG des Reset-Transistors anstelle des Lösch-Kontaktes beim Reset-Vorgang gepulst wird und dass ein zusätzlicher Anschluss für die konstante Löschspannung gebraucht wird.

Weiterhin ist zu erwähnen, dass in dem vorstehend beschriebenen Betriebsmodus gemäß Figur 4 auch Ladungspulse gemessen werden können, die beispielsweise von Röntgenphotonen herrühren. Diese Ladungspulse erscheinen dann als Spannungsspitzen auf einem Untergrund, der durch den langsamer variierenden, elektronengenerierten Anodenstrom bestimmt wird.

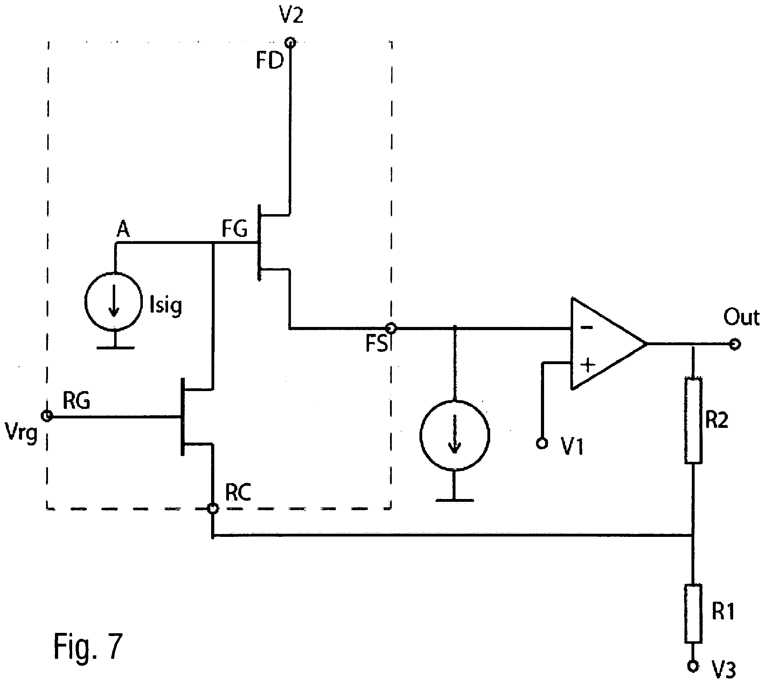

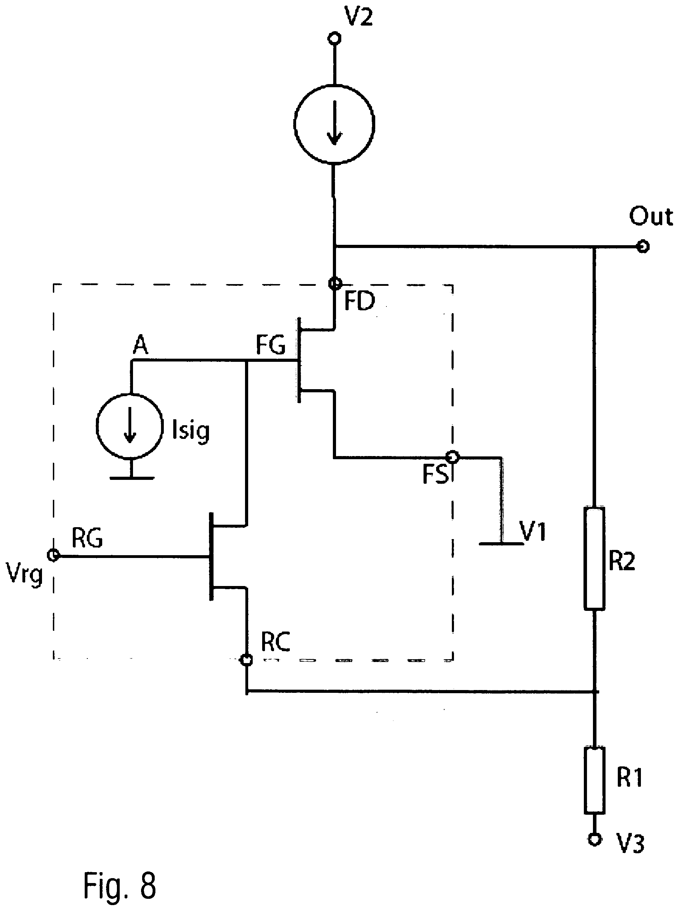

Eine Beschränkung in der Auslesegeschwindigkeit des Elektronenstroms ist durch die parasitären Kapazitäten des Sensors und der Ausleseelektronik gegeben. Durch Verwendung eines Driftdetektors und des darin integrierten Auslese-Transistors AT wurde die dominierende Kapazität bereits sehr klein gemacht. Eine zusätzliche Verbesserung ist dadurch zu erreichen, dass der Lösch-Kontakt RC nicht auf festem Potential gehalten wird, sondern als Rückkopplungselektrode verwendet, und deren Potential so nachgeführt wird, dass die Auslese-Anode A auf (fast) unverändertes Potential zurückgeführt wird. Zwei mögliche Schaltungen dafür sind in den Figuren 7 und 8 gezeigt.

Figur 7 betreibt den Auslese-Transistor AT in Sourcefolger-Schaltung. Der Ausgang der Source FS treibt einen Differenzverstärker, der das Signal invertiert. V1 legt das Sourcepotential, V2 das Drainpotential des Auslese-Transistors AT fest. Der Spannungsteiler R1, R2 zwischen Out und V3 reduziert die an dem Lösch-Kontakt RC zurückgeführte Rückkopplungsspannung. Das Potential V3 kann somit dazu benutzt werden, um das Pedestal der Ausgangsspannung einzustellen. Das Potential Vrg liegt an dem Gate RG des langkanaligen Reset-Transistors RT an, der im linearen Kennlinienbereich betrieben wird und damit Widerstandscharakteristik besitzt. Es stellt somit den Rückkopplungswiderstand ein.

Figur 8 betreibt den Auslese-Transistor AT in Common-Source-Schaltung, d.h. mit konstantem Source-Potential. V1 legt das Sourcepotential fest. Die mit einer Stromquelle verbundene Drain FD gibt die Ausgangsspannung. Der Spannungsteiler R1, R2 zwischen Out und V3 reduziert die an dem Lösch-Kontakt RC zurückgeführte Rückkopplungsspannung. Das Potential V3 kann somit dazu benutzt werden, um das Pedestal der Ausgangsspannung einzustellen. Das Potential Vrg liegt an dem Gate RG des langkanaligen Reset-Transistors RT an, der im linearen Kennlinienbereich betrieben wird und damit Widerstandscharakteristik besitzt. Es stellt somit den Rückkopplungswiderstand ein.

Die in Fig. 7 und 8 gezeigten Beispiele einer (externen) Rückkopplungsschaltung sind nur zwei von vielen Möglichkeiten. Das Wesentliche dieser Schaltungen ist die erfindungsgemäße Rückkopplung des Ausgangssignals in den Lösch-Kontakt RC des Reset-Transistors RT.

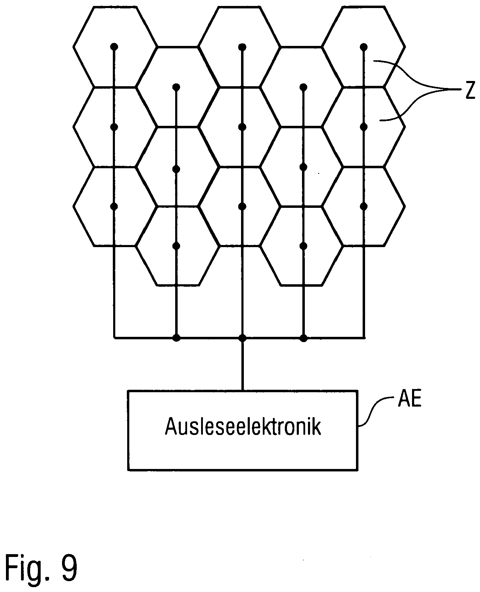

Figur 9 zeigt eine vereinfachte schematische Darstellung eines erfindungsgemäßen Halbleiterdriftdetektors, der weitgehend mit den vorstehend beschriebenen Ausführungsbeispielen übereinstimmt, so dass zur Vermeidung von Wiederholungen auf die vorstehende Beschreibung verwiesen wird.

Eine Besonderheit dieses Ausführungsbeispiels besteht darin, dass die Detektorfläche in mehrere Detektorzellen Z unterteilt sind, die jeweils nur einen Bruchteil der gesamten strahlungssensitiven Fläche des Halbleiterdriftdetektors abdecken.

Die einzelnen Detektorzellen Z sind hierbei hexagonal geformt und bilden eine hexagonale Packung, welche die gesamte strahlungssensitive Detektorfläche abdeckt.

Darüber hinaus weist der Halbleiterdriftdetektor in diesem Ausführungsbeispiel eine gemeinsame Ausleseelektronik AE auf, welche sämtliche Detektorzellen Z parallel ausliest.

Vorteilhaft an diesem Ausführungsbeispiel ist die Möglichkeit einer größeren Auslesegeschwindigkeit, da die strahlungsgenerierten Signalladungsträger innerhalb der einzelnen Detektorzellen Z aufgrund der geringeren räumlichen Ausdehnung der Detektorzellen Z eine geringer Driftdauer aufweisen.

Die Erfindung ist nicht auf die vorstehend beschriebenen bevorzugten Ausführungsbeispiele beschränkt. Vielmehr ist eine Vielzahl von Varianten und Abwandlungen möglich, die ebenfalls von dem Erfindungsgedanken Gebrauch machen und deshalb in den Schutzbereich fallen, der durch die Ansprüche definiert ist.

### Bezugszeichenliste:

- A: Auslese-Anode
- AE: Auslese-Elektronik
- AT: Auslese-Transistor
- dn: Vergrabene n-Dotierung
- dp: Tiefe p-Dotierung
- DR1: Driftring
- DR2: Driftring
- FD: Drain des Auslese-Transistors
- FG: Gate des Auslese-Transistors
- FS: Source des Auslese-Transistors
- HS: Halbleitersubstrat
- K: Leitungskanal
- R1: Widerstand des Spannungsteilers
- R2: Widerstand des Spannungsteilers
- RC: Lösch-Kontakt
- Rdp: Vergrabene p-Dotierung
- RG: Gate des Reset-Transistors
- RK: Rückkontakt
- RT: Reset-Transistor
- SL: Schlitz
- V1: Potential zur Festlegung des Sourcepotentials
- V2: Potential zur Festlegung des Drainpotentials
- V3: Potential zur Festlegung des Pedestals der Ausgangsspannung
- Vrg: Potential am Gate des Lösch-Transistors
- Out: Ausgang
- Z: Detektorzellen
- θ: Einfallende Elektronen
- h·f: Einfallende Photonen

## Patentansprüche

1. Halbleiterdriftdetektor zur Detektion von Strahlung, mit
a) einem Halbleitersubstrat (HS), in dem im Betrieb Signalladungsträger generiert werden und zwar
a1) durch einzelne einfallende Photonen (h·f), Ionen oder Elektronen mit einer zu bestimmenden Energie, insbesondere in Form von Röntgenfluoreszenzstrahlung, und/oder
a2) durch eine Vielzahl von einfallenden Elektronen (⊖), Ionen oder anderer ionisierender Strahlung mit einem bestimmten Signalladungsträgerstrom, insbesondere in Form von rückgestreuten Elektronen (⊖),
b) einer Auslese-Anode (A) zur Erzeugung eines elektrischen Ausgangssignals in Abhängigkeit von den Signalladungsträgern,
c) einem Lösch-Kontakt (RC) zum Löschen der in dem Halbleitersubstrat (HS) angesammelten Signalladungsträger,
**gekennzeichnet durch einen,**
d) in das Halbleitersubstrat (HS) integrierten langkanaligen Reset-Transistor (RT), der die Auslese-Anode (A) mit dem Lösch-Kontakt (RC) verbindet, um die photonengenerierten Signalladungsträger und/oder die elektronengenerierten Signalladungsträger zu dem Lösch-Kontakt (RC) abzuführen, wodurch die Messung des Signalladungsträgerstroms und die Messung der Photonenenergie ermöglicht wird, und weiterhin **dadurch gekennzeichnet,**
e) dass der langkanalige Reset-Transistor (RT) ein Gate (RG) aufweist und der Leitungskanal des langkanaligen Reset-Transistors (RT) einen elektrischen Widerstand aufweist, der **durch** Anlegen einer Gate-Spannung an das Gate (RG) des langkanaligen Reset-Transistors (RT) einstellbar ist,
f) dass der Halbleiterdriftdetektor wahlweise in einem ersten Betriebsmodus oder in einem zweiten Betriebsmodus betreibbar ist,
g) dass der Halbleiterdriftdetektor in dem ersten Betriebsmodus die Energie der einfallenden Photonen (h·f), Elektronen oder anderer ionisierender Teilchen misst,
h) dass der Halbleiterdriftdetektor in dem zweiten Betriebsmodus den Signalladungsträgerstrom misst, und weiterhin **dadurch gekennzeichnet**
i) **dass** der Halbleiterdriftdetektor mindestens einen Driftring (DR1, DR2) aufweist, der die Auslese-Anode (A) ringförmig umgibt und in dem Halbleitersubstrat (HS) ein elektrisches Driftfeld erzeugt, das die Signalladungsträger zu der Auslese-Anode (A) driften lässt, und
j) **dass** der innerste Driftring (DR1) von einem von innen nach außen verlaufenden Schlitz (SL) zumindest teilweise unterbrochen ist, und
k) **dass** der langkanalige Reset-Transistor (RT) in dem Schlitz (SL) des innersten Driftrings (DR1) angeordnet ist, wobei der Leitungskanal des langkanaligen Reset-Transistors (RT) entlang dem Schlitz (SL) verläuft.

2. Halbleiterdriftdetektor nach Anspruch 1, **dadurch gekennzeichnet,**
a) **dass** der langkanalige Reset-Transistor (RT) einen Leitungskanal mit einer bestimmten Kanallänge und einer bestimmten Kanalbreite aufweist, und
b) **dass** die Kanallänge größer ist als 10µm, 20µm, 50µm oder 100µm.

3. Halbleiterdriftdetektor nach einem der vorhergehenden Ansprüche, **gekennzeichnet durch** einen in das Halbleitersubstrat (HS) integrierten Auslese-Transistor (AT) mit einer Source (FS), einem Gate (FG) und einer Drain (FD), wobei das Gate (FG) des Auslese-Transistors (AT) elektrisch leitend mit der Auslese-Anode (A) verbunden ist.

4. Halbleiterdriftdetektor nach einem der vorhergehenden Ansprüche, **dadurch gekennzeichnet,**
a) **dass** der Schlitz (SL) radial verläuft,
b) **dass** der Schlitz (SL) in dem innersten Driftring (DR1) von innen nach außen durchgeht oder in dem Driftring endet, und
c) **dass** der Lösch-Kontakt (RC) an der Außenseite des innersten Driftrings (DR1) angeordnet ist.

5. Halbleiterdriftdetektor nach Anspruch 4.,
**dadurch gekennzeichnet,**
a) **dass** der Driftring (DR1) mit einem ersten Dotierungstyp dotiert ist, und
b) **dass** das Halbleitersubstrat (HS) in dem Schlitz (SL) des innersten Driftrings (DR1) mit einer tiefen Dotierungsimplantation (Rdp) des ersten Dotierungstyps unterlegt ist.

6. Halbleiterdriftdetektor nach einem der vorhergehenden Ansprüche, **dadurch gekennzeichnet,**
a) **dass** die Auslese-Anode (A) entsprechend einem zweiten Dotierungstyp dotiert ist und dass der Leitungskanal des langkanaligen Reset-Transistors (RT) eine tiefe Dotierungsimplantation (dn) des zweiten Dotierungstyps aufweist, wobei der zweite Dotierungstyp dem ersten Dotierungstyp entgegen gesetzt ist, oder
b) **dass** der langkanalige Reset-Transistor (RT) als Enhancement-Transistor ausgebildet ist, oder
c) **dass** der langkanalige Reset-Transistor (RT) als Depletion-Transistor ausgebildet ist, oder
d) **dass** der langkanalige Reset-Transistor (RT) als JFET ausgebildet ist.

7. Halbleiterdriftdetektor nach einem der vorhergehenden Ansprüche, **dadurch gekennzeichnet,**
a) **dass** ein Filter vorgesehen ist, das die einfallende Strahlung filtert,
b) **dass** das Filter die einfallenden Elektronen (⊖) unterhalb einer bestimmten Elektronenenergie größtenteils ausfiltert, aber die einfallenden Photonen (h·f) durchlässt.

8. Halbleiterdriftdetektor nach Anspruch 7,
**dadurch gekennzeichnet,**
a) **dass** das Filter direkt auf den Halbleiterdriftdetektor aufgebracht ist, oder
b) **dass** das Filter räumlich getrennt von dem Halbleiterdriftdetektor angeordnet ist.

9. Halbleiterdriftdetektor nach einem der vorhergehenden Ansprüche, **gekennzeichnet durch** mehrere Detektorzellen (Z) zur Detektion der einfallenden Strahlung,
wobei die Detektorzellen (Z) räumlich voneinander getrennt sind und entsprechend der einfallenden Strahlung unabhängig voneinander Signalladungsträger ansammeln.

10. Halbleiterdriftdetektor nach Anspruch 9,
**dadurch gekennzeichnet,**
a) **dass** die einzelnen Detektorzellen (Z) jeweils eine separate Auslese-Elektronik aufweisen, oder
b) **dass** die einzelnen Detektorzellen (Z) eine gemeinsame Auslese-Elektronik (AE) aufweisen, welche die Detektorzellen (Z) parallel ausliest.

11. Halbleiterdriftdetektor nach Anspruch 9 oder 10,
**dadurch gekennzeichnet,**
a) **dass** die Detektorzellen (Z) jeweils hexagonal sind, und/oder
b) **dass** die Detektorzellen (Z) gemeinsam auf demselben Halbleitersubstrat angeordnet sind.

12. Halbleiterdriftdetektor nach einem der Ansprüche 10 oder 11 soweit von Anspruch 10 abhängig, **dadurch gekennzeichnet,**
a) **dass** die gemeinsame Auslese-Elektronik (AE) für jede der Detektorzellen (Z) jeweils einen Auslesetransistor mit einer Source, einer Drain, einem Gate und einem Leitungskanal zwischen der Source und der Drain aufweist, und
b) **dass** die Auslese-Transistoren der Detektorzellen (Z) jeweils mit ihrer Source untereinander elektrisch verbunden sind, und/oder
c) **dass** die Auslese-Transistoren der Detektorzellen (Z) jeweils mit ihrer Drain untereinander elektrisch verbunden sind.

13. Halbleiterdriftdetektor nach Anspruch 12,
**dadurch gekennzeichnet,**
a) **dass** die einzelnen Detektorzellen zum Löschen der in der jeweiligen Detektorzellen angesammelten Signalladungsträger jeweils einen Lösch-Kontakt aufweisen und
b) **dass** die Auslese-Transistoren der Detektorzellen jeweils mit ihrem Löschkontakt untereinander elektrisch verbunden sind.

14. Detektoranordnung mit
a) einem Halbleiterdriftdetektor nach einem der vorhergehenden Ansprüche, und
b) einer externen Rückkopplungsschaltung, die ein Rückkopplungssignal erzeugt, das über den Lösch-Kontakt (RC) des langkanaligen Reset-Transistors (RT) in den Halbleiterdriftdetektor zurückgeführt wird.

15. Elektronenmikroskop mit einem Halbleiterdriftdetektor nach einem Ansprüche 1-13 zur Messung von Fluoreszenzstrahlung und zur Messung von rückgestreuten Elektronen (e).

16. Verwendung eines Halbleiterdriftdetektors nach einem der Ansprüche 1-13 zur zeitlich aufgelösten Elektronenstrommessung.

17. Verwendung eines Halbleiterdriftdetektors nach einem der Ansprüche 1-13 in Kombination mit einer elektrostatischen oder magnetischen Elektronen- oder Ionenfalle.

18. Betriebsverfahren für einen Halbleiterdriftdetektor nach einem der Ansprüche 1 bis 13, **dadurch gekennzeichnet, dass** der Halbleiterdriftdetektor wahlweise in dem ersten Betriebsmodus oder in einem zweiten Betriebsmodus betrieben wird, dass der Halbleiterdriftdetektor in dem ersten Betriebsmodus die Photonenenergie der einfallenden Photonen (h·f) misst, und dass der Halbleiterdriftdetektor in dem zweiten Betriebsmodus den Signalladungsträgerstrom misst.

19. Betriebsverfahren nach Anspruch 18,
**gekennzeichnet durch** folgende Schritte:
a) Abführen der photonengenerierten Signalladungsträger und/oder der elektronengenerierten Signalladungsträger zu dem Lösch-Kontakt (RC) über den in das Halbleitersubstrat (HS) integrierten langkanaligen Reset-Transistor (RT), der die Auslese-Anode (A) mit dem Lösch-Kontakt (RC) verbindet, wobei der langkanalige Reset-Transistor (RT) vorzugsweise im Schwellenbereich betrieben wird, und
b) Messen des Spannungsabfalls über dem Leitungskanal des langkanaligen Reset-Transistors (RT) als Maß für den Signalladungsträgerstrom der einfallenden Elektronen (e) und/oder
c) Messen der zeitlichen Veränderung des Spannungsabfalls über dem Leitungskanal des langkanaligen Reset-Transistors (RT) als Maß für die Photonenenergie der einfallenden Photonen (h·f).

20. Betriebsverfahren nach einem der Ansprüche 18 bis 19,
**dadurch gekennzeichnet,**
a) **dass** in das Halbleitersubstrat (HS) ein Auslese-Transistor (AT) mit einer Source (FS), einem Gate (FG) und einer Drain (FD) integriert ist, wobei der Auslese-Transistor (AT) elektrisch leitend mit der Auslese-Anode (A) verbunden ist, und
b) **dass** der Auslese-Transistor (AT) als Source-Folger betrieben wird und das Potential der Auslese-Anode (A) niederohmig nach außen überträgt.

21. Betriebsverfahren nach einem der Ansprüche 18 bis 20,
**dadurch gekennzeichnet, dass** das Gate (RG) des langkanaligen Reset-Transistors (RT) zum Löschen gepulst wird, um die Auslese-Anode (A) auf das Potential des Lösch-Kontaktes (RC) zu bringen und den langkanaligen Reset-Transistor (RT) anschließend wieder für die Messung der strahlungsgenerierten Signalladungsträger zu sperren.

22. Betriebsverfahren nach einem der Ansprüche 18 bis 20,
**dadurch gekennzeichnet, dass** das Gate (RG) des langkanaligen Reset-Transistors (RT) und der Lösch-Kontakt (RC) auf feste elektrische Potentiale gelegt werden, so dass sich das elektrische Potential der Auslese-Anode (A) in Abwesenheit von Ladungssignalen auf ein festes Potential einstellt, dessen Wert sich im Wesentlichen durch das Potential des Gates (RG) des langkanaligen Reset-Transistors (RT) und durch die Schwellenspannung des langkanaligen Reset-Transistors (RT) ergibt.

23. Betriebsverfahren nach einem der Ansprüche 18 bis 22, **gekennzeichnet durch** folgenden Schritt:
a) Messen des Potentials der Auslese-Anode (A) als Maß für den Signalladungsträgerstrom der einfallenden Elektronen (⊖) und/oder
b) Messen eines Potentialsprungs des Potentials der Auslese-Anode (A) als Maß für die Photonenenergie der einfallenden Photonen (h·f).

24. Betriebsverfahren nach einem der Ansprüche 20 oder 21 soweit auf Anspruch 20 rückbezogen, **dadurch gekennzeichnet,**
a) **dass** eine externe Elektronik nur ein Ausgangssignal des Auslese-Transistors (AT) innerhalb eines begrenzten Arbeitsbereichs verarbeiten kann, und
b) **dass** die zu messenden Signalladungsträger im Betrieb einen bestimmten Maximalwert nicht überschreiten, und
c) **dass** das Gate (RG) des langkanaligen Reset-Transistors (RT) so angesteuert wird, dass der Spannungsabfall über dem als steuerbarer Widerstand wirkenden langkanaligen Reset-Transistor (RT) auch bei dem Maximalwert der Signalladungsträger nicht dazu führt, dass das Ausgangssignal des Auslese-Transistors (AT) den Arbeitsbereich der externen Elektronik überschreitet.

25. Betriebsverfahren nach Anspruch 24,
**dadurch gekennzeichnet,**
a) **dass** die externe Elektronik nur ein Ausgangssignal des Auslese-Transistors (AT) innerhalb eines begrenzten Arbeitsbereichs verarbeiten kann, und
b) **dass** die zu messenden Signalladungsträger im Betrieb einen bestimmten Minimalwert nicht unterschreiten, und
c) **dass** das Gate des langkanaligen Reset-Transistors (RT) so angesteuert wird, dass der Spannungsabfall über dem als steuerbarer Widerstand wirkenden langkanaligen Reset-Transistor (RT) auch bei dem Minimalwert der Signalladungsträger nicht dazu führt, dass das Ausgangssignal des Auslese-Transistors (AT) den Arbeitsbereich der externen Elektronik unterschreitet.

## Claims

1. Semiconductor drift detector for detecting radiation, comprising
a) a semiconductor substrate (HS) in which signal charge carriers are generated during operation,
a1) by individual incident photons (h·f), ions or electrons having an energy that is to be determined, in particular in the form of X-ray fluorescence radiation, and/or
a2) by a plurality of incident electrons (e), ions or other ionising radiation having a specific signal charge carrier current, in particular in the form of backscattered electrons (e),
b) a read-out anode (A) for generating an electrical output signal depending on the signal charge carriers,
c) an erase contact (RC) for erasing the signal charge carriers that have accumulated in the semiconductor substrate (HS),
**characterised by** a
d) long-channel reset transistor (RT) which is integrated in the semiconductor substrate (HS) and connects the read-out anode (A) to the erase contact (RC) in order to discharge the photon-generated signal charge carriers and/or the electron-generated signal charge carriers to the erase contact (RC), which makes it possible to measure the signal charge carrier current and the photon energy, and further **characterised in that**
e) the long-channel reset transistor (RT) has a gate (RG), and the channel of the long-channel reset transistor (RT) has an electrical resistance, which can be adjusted by applying a gate voltage to the gate (RG) of the long-channel reset transistor (RT),
f) the semiconductor drift detector can be selectively operated in a first operating mode or in a second operating mode,
g) in the first operating mode, the semiconductor drift detector measures the energy of the incident photons (h·f), electrons or other ionising particles,
h) in the second operating mode, the semiconductor drift detector measures the signal charge carrier current, and further **characterised in that**
i) the semiconductor drift detector has at least one drift ring (DR1, DR2), which annularly surrounds the read-out anode (A) and generates an electrical drift field in the semiconductor substrate (HS), so that the signal charge carriers drift to the read-out anode (A), and
j) the innermost drift ring (DR1) is interrupted, at least in part, by a slot (SL) extending from inside to outside, and
k) the long-channel reset transistor (RT) is arranged in the slot (SL) in the innermost drift ring (DR1), wherein the channel of the long-channel reset transistor (RT) extends along the slot (SL).

2. Semiconductor drift detector according to claim 1, **characterised in that**
a) the long-channel reset transistor (RT) has a channel having a specific channel length and a specific channel width, and
b) the channel length is greater than 10 µm, 20 µm, 50 µm or 100 µm.

3. Semiconductor drift detector according to any of the preceding claims, **characterised by** a read-out transistor (AT) which is integrated in the semiconductor substrate (HS) and comprises a source (FS), a gate (FG) and a drain (FD), the gate (FG) of the read-out transistor (AT) being electrically conductively connected to the read-out anode (A).

4. Semiconductor drift detector according to any of the preceding claims, **characterised in that**
a) the slot (SL) extends radially,
b) the slot (SL) in the innermost drift ring (DR1) passes from the inside through to the outside, or ends in the drift ring, and
c) the erase contact (RC) is arranged on the outside of the innermost drift ring (DR1).

5. Semiconductor drift detector according to claim 4, **characterised in that**
a) the drift ring (DR1) is doped with a first doping type, and
b) the semiconductor substrate (HS) is underlaid, in the slot (SL) in the innermost drift ring (DR1), with a deep doping implantation (Rdp) of the first doping type.

6. Semiconductor drift detector according to any of the preceding claims, **characterised in that**
a) the read-out anode (A) is doped according to a second doping type, and the channel of the long-channel reset transistor (RT) has a deep doping implantation (dn) of the second doping type, the second doping type being opposite to the first doping type, or
b) the long-channel reset transistor (RT) is an enhancement transistor, or
c) the long-channel reset transistor (RT) is a depletion transistor, or
d) the long-channel reset transistor (RT) is a JFET.

7. Semiconductor drift detector according to any of the preceding claims, **characterised in that**
a) a filter is provided, which filters the incident radiation,
b) the filter largely filters out the incident electrons (e) below a specific electron energy, but allows the incident photons (h·f) to pass through.

8. Semiconductor drift detector according to claim 7, **characterised in that**
a) the filter is mounted directly on the semiconductor drift detector, or
b) the filter is arranged so as to be spatially separated from the semiconductor drift detector.

9. Semiconductor drift detector according to any of the preceding claims, **characterised by** a plurality of detector cells (Z) for detecting the incident radiation, the detector cells (Z) being spatially separated from one another and, independently of one another, accumulating signal charge carriers according to the incident radiation.

10. Semiconductor drift detector according to claim 9, **characterised in that**
a) the individual detector cells (Z) each have a separate read-out electronic system, or
b) the individual detector cells (Z) have a common read-out electronic system (AE), which reads out the detector cells (Z) in parallel.

11. Semiconductor drift detector according to either claim 9 or claim 10, **characterised in that**
a) the detector cells (Z) are each hexagonal, and/or
b) the detector cells (Z) are arranged together on the same semiconductor substrate.

12. Semiconductor drift detector according to either claim 10 or claim 11, insofar as the latter is dependent on claim 10, **characterised in that**
a) the common read-out electronic system (AE) has, for each of the detector cells (Z), a read-out transistor comprising a source, a drain, a gate and a channel between the source and the drain, and
b) the read-out transistors of the detector cells (Z) are each electrically interconnected by means of the source thereof, and/or
c) the read-out transistors of the detector cells (Z) are each electrically interconnected by means of the drain thereof.

13. Semiconductor drift detector according to claim 12, **characterised in that**
a) the individual detector cells each have an erase contact in order to erase the signal charge carriers which have accumulated in the respective detector cell, and
b) the read-out transistors of the detector cells are each electrically interconnected by means of the erase contact thereof.

14. Detector arrangement comprising
a) a semiconductor drift detector according to any of the preceding claims, and
b) an external feedback circuit, which generates a feedback signal which is fed back to the semiconductor drift detector via the erase contact (RC) of the long-channel reset transistor (RT).

15. Electron microscope comprising a semiconductor drift detector according to any of claims 1-13 for measuring fluorescence radiation and for measuring backscattered electrons (e).

16. Use of a semiconductor drift detector according to any of claims 1-13 for measuring electron current in a time-resolved manner.

17. Use of a semiconductor drift detector according to any of claims 1-13 in combination with an electrostatic or magnetic electron trap or ion trap.

18. Operating method for a semiconductor drift detector according to any of claims 1 to 13, **characterised in that**
the semiconductor drift detector is selectively operated in the first operating mode or in a second operating mode,
in the first operating mode, the semiconductor drift detector measures the photon energy of the incident photons (h·f), and,
in the second operating mode, the semiconductor drift detector measures the signal charge carrier current.

19. Operating method according to claim 18, **characterised by** the following steps:
a) discharging the photon-generated signal charge carriers and/or the electron-generated signal charge carriers to the erase contact (RC) via the long-channel reset transistor (RT) which is integrated in the semiconductor substrate (HS) and connects the read-out anode (A) to the erase contact (RC), the long-channel reset transistor (RT) preferably being operated in the threshold range, and
b) measuring the voltage drop across the channel of the long-channel reset transistor (RT) as a measure of the signal charge carrier current of the incident electrons (e) and/or
c) measuring the temporal variation of the voltage drop across the channel of the long-channel reset transistor (RT) as a measure of the photon energy of the incident photons (h·f).

20. Operating method according to either claim 18 or claim 19, **characterised in that**
a) a read-out transistor (AT) comprising a source (FS), a gate (FG) and a drain (FD) is integrated in the semiconductor substrate (HS), the read-out transistor (AT) being electrically conductively connected to the read-out anode (A), and
b) the read-out transistor (AT) is operated as a source follower and transfers the potential of the read-out anode (A) to the outside in a low-resistance manner.

21. Operating method according to any of claims 18 to 20, **characterised in that**, for the erasure process, the gate (RG) of the long-channel reset transistor (RT) is pulsed in order to bring the read-out anode (A) to the potential of the erase contact (RC) and to subsequently block the long-channel reset transistor (RT) again for measuring the radiation-generated signal charge carriers.

22. Operating method according to any of claims 18 to 20, **characterised in that** the gate (RG) of the long-channel reset transistor (RT) and the erase contact (RC) are provided at a fixed electric potentials, so that the electric potential of the read-out anode (A) is set, in the absence of charge signals, at a fixed potential, the value of which potential results substantially from the potential of the gate (RG) of the long-channel reset transistor (RT) and from the threshold voltage of the long-channel reset transistor (RT).

23. Operating method according to any of claims 18 to 22, **characterised by** the following step:
a) measuring the potential of the read-out anode (A) as a measure of the signal charge carrier current of the incident electrons (e) and/or
b) measuring a potential jump of the potential of the read-out anode (A) as a measure of the photon energy of the incident photons (h·f).

24. Operating method according to either claim 20 or claim 21, insofar as the latter is dependent on claim 20, **characterised in that**
a) an external electronic system can only process an output signal from the read-out transistor (AT) within a limited working range, and
b) during operation, the signal charge carriers to be measured do not exceed a specific maximum value, and
c) the gate (RG) of the long-channel reset transistor (RT) is actuated such that the voltage drop across the long-channel reset transistor (RT), which acts as a controllable resistor, does not lead to the output signal of the read-out transistor (AT) exceeding the working range of the external electronic system, even in the case of the maximum value of the signal charge carriers.

25. Operating method according to claim 24, **characterised in that**
a) the external electronic system can only process an output signal of the read-out transistor (AT) within a limited working range, and
b) during operation, the signal charge carriers to be measured do not fall below a specific minimum value, and
c) the gate of the long-channel reset transistor (RT) is actuated such that the voltage drop across the long-channel reset transistor (RT), which acts as a controllable resistor, does not lead to the output signal of the read-out transistor (AT) falling below the working range of the external electronic system, even in the case of the minimum value of the signal charge carriers.

## Revendications

1. Détecteur à dérive à semi-conducteur pour la détection de rayonnement, doté
a) d'un substrat semi-conducteur (HS) dans lequel, en fonctionnement, sont générés des porteurs de charge de signal et ce
a1) par des photons (h·f), ions ou électrons individuels incidents, avec une énergie qui doit être déterminée, notamment sous la forme de rayonnement par fluorescence X, et/ou
a2) par une pluralité d'électrons (θ), ions ou un autre rayonnement ionisant incidents, avec un certain courant porteur de charge de signal, notamment sous la forme d'électrons (θ) rétrodiffusés,
b) une anode de lecture (A) pour générer un signal électrique de sortie en fonction des porteurs de charge de signal,
c) un contact d'effacement (RC) pour effacer les porteurs de charge de signal accumulés dans le substrat semi-conducteur (HS)
**caractérisé par** un
d) transistor de réinitialisation (RT) à canal long intégré dans le substrat semi-conducteur (HS), qui relie l'anode de lecture (A) avec le contact d'effacement (RC), pour évacuer les porteurs de charge de signal générés par photons et/ou les porteurs de charge de signal générés par électrons vers le contact d'effacement (RC), ce par quoi la mesure du courant porteur de charge de signal et la mesure de l'énergie photonique deviennent possibles, et **caractérisé par** ailleurs
e) en ce que le transistor de réinitialisation (RT) à canal long comporte une grille (RG) et en ce que le canal conducteur du transistor de réinitialisation (RT) à canal long comporte une résistance électrique qui est réglable par application d'une tension de grille sur la grille (RG) du transistor de réinitialisation (RT) à canal long,
f) en ce que le détecteur à dérive à semi-conducteur peut fonctionner au choix dans un premier mode de fonctionnement ou dans un deuxième mode de fonctionnement,
g) en ce que, dans le premier mode de fonctionnement, le détecteur à dérive à semi-conducteur mesure l'énergie des photons (h·f), électrons ou autres particules ionisantes incidents,
h) en ce que, dans le deuxième mode de fonctionnement, le détecteur à dérive à semi-conducteur mesure le courant porteur de charge de signal, et **caractérisé par** ailleurs
i) en ce que le détecteur à dérive à semi-conducteur présente au moins une dérive (DR1, DR2), qui entoure en forme d'anneau l'anode de lecture (A) et génère dans le substrat semi-conducteur (HS) un champ de dérive électrique qui laisse dériver les porteurs de charge de signal vers l'anode de lecture (A), et
j) en ce que la dérive (DR1) la plus à l'intérieur est interrompue au moins partiellement par une encoche (SL) s'étendant de l'intérieur vers l'extérieur, et
k) en ce que le transistor de réinitialisation (RT) à canal long est placé dans l'encoche (SL) de la dérive (DR1) la plus à l'intérieur, le canal conducteur du transistor de réinitialisation (RT) à canal long s'étendant le long de l'encoche (SL).

2. Détecteur à dérive à semi-conducteur selon la revendication 1, **caractérisé en ce que**
a) le transistor de réinitialisation (RT) à canal long comporte un canal conducteur d'une longueur de canal déterminée et d'une largeur de canal déterminée,
b) **en ce que** la longueur de canal est supérieure à 10 µm, 20 µm, 50 µm ou 100 µm.

3. Détecteur de la dérive d'un semi-conducteur selon l'une des revendications précédentes,
**caractérisé par** un transistor de lecture (AT) intégré dans le substrat semi-conducteur (HS), doté d'une source (FS), d'une grille (FG) et d'un drain (FD), la grille (FG) du transistor de lecture (AT) étant reliée de manière électriquement conductrice avec l'anode de lecture (A).

4. Détecteur à dérive à semi-conducteur selon l'une des revendications précédentes,
**caractérisé**
a) **en ce que** l'encoche (SL) s'étend en direction radiale,
b) **en ce que** l'encoche (SL) traverse de l'intérieur vers l'extérieur la dérive (DR1) la plus à l'intérieur ou se termine dans la dérive
et
c) **en ce que** le contact d'effacement (RC) est placé sur la face extérieure de la dérive (DR1) la plus à l'intérieur.

5. Détecteur de la dérive d'un semi-conducteur selon la revendication 4,
**caractérisé en ce que**
a) la dérive (DR1) est dopée avec un premier type de dopage et
b) **en ce que** dans l'encoche (SL) de la dérive (DR1) la plus à l'intérieur, le substrat semi-conducteur (IIS) est calé avec une implantation de dopage profonde (Rdp) du premier type de dopage.

6. Détecteur à dérive à semi-conducteur selon l'une des revendications précédentes,
**caractérisé**
a) **en ce que** l'anode de lecture (A) est dopée conformément à un deuxième type de dopage et en ce que le canal conducteur du transistor de réinitialisation (RT) à canal long comporte une implantation de dopage profonde (dn) du deuxième type de dopage, le deuxième type de dopage étant à l'opposé du premier type de dopage ou
b) **en ce que** le transistor de réinitialisation (RT) à canal long est conçu sous la forme d'un transistor à enrichissement ou
c) **en ce que** le transistor de réinitialisation (RT) à canaux longs est conçu sous la forme d'un transistor à appauvrissement ou
d) **en ce que** le transistor de réinitialisation (RT) à canaux longs est conçu sous la forme d'un transistor JFET.

7. Détecteur à dérive à semi-conducteur selon l'une des revendications précédentes,
**caractérisé**
a) **en ce qu'**il est prévu un filtre qui filtre le rayonnement incident,
b) **en ce que** le filtre élimine en majeure partie par filtrage les électrons (θ) incidents en-dessous d'une énergie d'électron déterminée, mais laisse passer les photons (h·f) incidents.

8. Détecteur à dérive à semi-conducteur selon la revendication 7,
**caractérisé**
a) **en ce que** le filtre est monté directement sur le détecteur à dérive à semi-conducteur ou
b) **en ce que** le filtre est spatialement séparé du détecteur à dérive à semi-conducteur.

9. Détecteur à dérive à semi-conducteur selon l'une des revendications précédentes,
**caractérisé par** plusieurs cellules détectrices (Z) pour la détection du rayonnement incident,
les cellules détectrices (Z) étant spatialement séparées les unes des autres et accumulant indépendamment les unes des autres, en fonction du rayonnement incident, des porteurs de charge de signal.

10. Détecteur à dérive à semi-conducteur selon la revendication 9,
**caractérisé**
a) **en ce que** les cellules détectrices (Z) individuelles comportent respectivement une électronique de lecture séparée ou
b) **en ce que** les cellules détectrices (Z) individuelles comportent une électronique de lecture (AE) commune, laquelle lit les cellules détectrices (Z) en parallèle.

11. Détecteur à dérive à semi-conducteur selon la revendication 9 ou 10,
**caractérisé**
a) **en ce que** les cellules détectrices (Z) sont respectivement hexagonales et/ou
b) **en ce que** les cellules détectrices (Z) sont placées en commun sur le même substrat semi-conducteur.

12. Détecteur à dérive à semi-conducteur selon l'une des revendications 10 ou 11, dans la mesure où elle dépend de la revendication 10,
**caractérisé en ce que**
a) l'électronique de lecture (AE) commune comporte pour chacune des cellules détectrices (Z) respectivement un transistor de lecture avec une source, un drain, une grille et un canal conducteur entre la source et le drain, et
b) **en ce que** les transistors de lecture des cellules détectrices (Z) sont respectivement reliés électriquement entre eux par leur source, et/ou
c) **en ce que** les transistors de lecture des cellules détectrices (Z) sont respectivement reliés électriquement entre eux par leur drain.

13. Détecteur à dérive à semi-conducteur selon la revendication 12,
**caractérisé**
a) **en ce que**, pour effacer les porteurs de charge de signal accumulés dans les cellules détectrices respectives, les cellules détectrices individuelles comportent respectivement un contact d'effacement et
b) **en ce que** les transistors de lecture des cellules détectrices sont respectivement reliés électriquement entre eux par leur contact d'effacement.

14. Ensemble détecteur, doté
a) d'un détecteur à dérive à semi-conducteur selon l'une des revendications précédentes et
b) d'un circuit de rétroaction externe qui génère un signal de rétroaction qui est ramené dans le détecteur à dérive à semi-conducteur par l'intermédiaire du contact d'effacement (RC) du transistor de réinitialisation (RT) à canal long.

15. Microscope électronique doté d'un détecteur à dérive à semi-conducteur selon l'une des revendications 1 à 13, pour mesurer un rayonnement de fluorescence et pour mesurer des électrons (θ) rétrodiffusés.

16. Utilisation d'un détecteur à dérive à semi-conducteur selon l'une quelconque des revendications 1 à 13 pour la mesure décomposée dans le temps d'un flux d'électrons.

17. Utilisation d'un détecteur à dérive à semi-conducteur selon l'une des revendications 1 à 13, en association avec un piège à électrons ou piège à ions électrostatique ou magnétique.

18. Procédé de fonctionnement d'un détecteur à dérive à semi-conducteur selon l'une des revendications 1 à 13,
**caractérisé**
**en ce qu'**on fait fonctionner au choix le détecteur à dérive à semi-conducteur dans le premier mode de fonctionnement ou dans un deuxième mode de fonctionnement,
**en ce que** dans le premier mode de fonctionnement, le détecteur à dérive à semi-conducteur mesure l'énergie photonique des photons (h·f) incidents,
et
**en ce que**, dans le deuxième mode de fonctionnement, le détecteur à dérive à semi-conducteur mesure le courant porteur de charge de signal.

19. Procédé de fonctionnement selon la revendication 18,
**caractérisé par** les étapes suivantes :
a) évacuation des porteurs de charge de signal générés par photons et/ou des porteurs de charge de signal générés par électrons vers le contact d'effacement (RC), par l'intermédiaire du transistor de réinitialisation (RT) à canal long intégré dans le substrat semi-conducteur (HS) qui relie l'anode de lecture (A) avec le contact d'effacement (RC), lors duquel on fait fonctionner le transistor de réinitialisation (RT) à canal long de préférence dans la zone de seuil, et
b) mesure de la chute de tension sur le canal conducteur du transistor de réinitialisation (RT) à canal long, en tant que dimension pour le courant porteur de charge de signal des électrons (θ) incidents, et/ou
c) mesure de la modification dans le temps de la chute de tension sur le canal conducteur du transistor de réinitialisation (RT) à canal long, en tant que mesure de l'énergie photonique des photons (h·f) incidents.

20. Procédé de fonctionnement selon l'une des revendications 18 à 19,
**caractérisé**
a) **en ce que** dans le substrat de semi-conducteur (HS) est intégré un transistor de lecture (AT), avec une source (FS), une grille (FG) et un drain (FD), le transistor de lecture (AT) étant relié de manière électriquement conductrice avec l'anode de lecture (A) et
b) **en ce qu'**on fait fonctionner le transistor de lecture (AT) en tant que suiveur de source et en ce qu'il transmet le potentiel de l'anode de lecture (A) à basse impédance vers l'extérieur.

21. Procédé de fonctionnement selon l'une des revendications 18 à 20,
**caractérisé en ce qu'**on impulse la grille (RG) du transistor de réinitialisation (RT) à canal long en effacement pour amener l'anode de lecture (A) au potentiel du contact d'effacement (RC) et pour rebloquer ensuite le transistor de réinitialisation (RT) à canal long pour la mesure des porteurs de charge de signal générés par rayonnement.

22. Procédé de fonctionnement selon l'une des revendications 18 à 20,
**caractérisé en ce qu'**on amène la grille (RG) du transistor de réinitialisation (RT) à canal long et du contact d'effacement (RC) à des potentiels électriques fixes, de sorte qu'en l'absence de signaux de charge, le potentiel électrique de l'anode de lecture (A) se règle sur un potentiel fixe dont la valeur résulte sensiblement du potentiel de la grille (RG) du transistor de réinitialisation (RT) à canal long et de la tension seuil du transistor de réinitialisation (RT) à canal long.

23. Procédé de fonctionnement selon l'une des revendications 18 à 22, **caractérisé par** les étapes suivantes :
a) mesure du potentiel de l'anode de lecture (A) en tant que dimension pour le courant porteur de charge de signal des électrons (θ) incidents et/ou
b) mesure d'un saut de potentiel du potentiel de l'anode de lecture (A) en tant que dimension pour l'énergie photonique des photons (h·f) incidents.

24. Procédé de fonctionnement selon l'une quelconque des revendications 20 ou 21, dans la mesure où elle dépend de la revendication 20,
**caractérisé**
a) **en ce qu'**une électronique externe ne peut traiter qu'un signal de sortie du transistor de lecture (AT) à l'intérieur d'une plage de travail limitée et
b) **en ce que** les porteurs de charge de signal qui doivent être mesurés ne dépassent pas en fonctionnement une valeur maximale déterminée et
c) **en ce qu'**on excite la grille (RG) du transistor de réinitialisation (RT) à canal long de telle sorte qu'également à la valeur maximale des porteurs de charge de signal, la chute de tension sur le transistor de réinitialisation (RT) à canal long agissant comme une résistance commandable n'ait pas pour conséquence que le signal de sortie du transistor de lecture (AT) dépasse la plage de travail de l'électronique externe.

25. Procédé de fonctionnement selon la revendication 24,
**caractérisé**
a) **en ce que** l'électronique externe ne peut traiter qu'un signal de sortie du transistor de lecture (AT) à l'intérieur d'une plage de travail limitée et
b) **en ce que** les porteurs de charge de signal qui doivent être mesurés ne sont pas inférieurs en fonctionnement à une certaine valeur minimale et
c) **en ce qu'**on excite la grille du transistor de réinitialisation (RT) à canal long de telle sorte qu'également à la valeur minimale des porteurs de charge de signal, la chute de tension sur le transistor de réinitialisation (RT) à canal long agissant comme une résistance commandable n'ait pas pour conséquence que le signal de sortie du transistor de lecture (AT) soit inférieur à la plage de travail de l'électronique externe.
